# EUROPEAN PATENT APPLICATION

(11) **EP 1 724 374 A1**
(43) Date of publication of application: **22.11.2006**
(21) Application number: 06009536.1
(22) Date of filing: 09.05.2006
(51) Int. Cl.: C23C 16/44

(54) **Method and process for reactive gas cleaning of tool parts**

(30) Priority: 16.05.2005 US 130307
(71) Applicant: Air Products and Chemicals, Inc., Allentown, PA 18195-1501 (US)
(72) Inventor: Wu, Dingjun, Macungie, PA 18062 (US); Karwacki, Eugene Joseph, Jr., Orefield, PA 18069 (US); Ji, Bing, Pleasanton, CA 94566 (US)
(74) Representative: Schwabe - Sandmair - Marx

(57) **Abstract**

This invention relates to an improvement in the cleaning of contaminated tool parts having a coating of unwanted residue formed in a semiconductor deposition chamber. In this process, the contaminated parts to be cleaned are removed from the semiconductor deposition chamber and placed in a reaction chamber off-line from the semiconductor reactor deposition chamber, i.e. on off-line gas reaction chamber. The coating of residue on the contaminated parts is removed in an off-line reactor by contacting the contaminated parts with a reactive gas under conditions for converting the residue to a volatile species while in said off-line reactor and then removing the volatile species from said off-line gas reaction chamber.

## Description

### BACKGROUND OF THE INVENTION

In the electronics industry, various deposition techniques have been developed wherein select materials are deposited on a target substrate to produce electronic components such as semiconductors. One type of deposition process is chemical vapor deposition (CVD), wherein gaseous reactants are introduced into a heated processing chamber resulting in films being deposited on the desired substrate.

Generally, all methods of deposition, e.g., CVD, ALD, PVD, and PECVD result in the accumulation of films and particulate materials on all surfaces and equipment in the semiconductor deposition chamber other than the target substrate. Any material, film and the like that builds up on the reactor walls, tool parts such as tool surfaces, shower heads, susceptors and other equipment is considered a contaminant and may lead to defects in the electronic product component.

It is well accepted that semiconductor deposition chambers and equipment must be periodically cleaned to remove unwanted contaminating deposition materials. Certain fixtures, i.e., tool parts, inside a deposition chamber are often cleaned off-line. This kind of off-line cleaning is commonly referred to as "parts" cleaning. Parts cleaning is particularly effective when cleaning of the entire chamber is not feasible or necessary. Conventionally, parts within the deposition chamber are cleaned off-line using a mechanical method, such as blasting, or a wet method, such as dipping in an acid or caustic solution. The combination of mechanical and wet methods can be used to remove some hard and chemically resistive materials. Both mechanical and wet methods are labor intensive, and neither is environmentally friendly.

The following references are illustrative of processes for the deposition of films in semiconductor manufacture and the cleaning of deposition chambers:

US 2003/0109138 A1 discloses a process for etching a layer of tantalum within a semiconductor structure using a plasma source gas such as NF₃ or SF₆ in combination with a carbon containing fluorine gas, e.g., CₓH_{y}F_{z}. The use of a remote plasma to remove deposits comprising Ta formed on the interior surface of the processing chamber is also described.

US 6,274,058 B1, discloses an *in situ* process for the remote plasma cleaning of processing chambers, particularly those employed for the deposition of tantalum. Reactive gases suited for cleaning deposition products within the chamber include halogen gases, e.g., NF₃, F₂, CF₄, SF₆, C₂F₆, CCl₄, and C₂Cl₆.

US 5,421,957 discloses a process for the low temperature cleaning of cold-wall CVD chambers. The process is carried out, *in situ,* under moisture free conditions. Cleaning of films of various materials such as epitaxial silicon, polysilicon, silicon nitride, silicon oxide, and refractory metals, titanium, tungsten and their silicides is effected using an etchant gas, e.g., nitrogen trifluoride, chlorine trifluoride, sulfur hexafluoride, and carbon tetrafluoride. NF₃ etching of chamber walls at temperatures of 400-600°C is shown.

US 6,067,999 discloses a two step cleaning process to control and minimize the emission of environmentally deleterious materials and comprises the steps of establishing a process temperature; providing a 15-25% mixture of NF₃ in an inert gas, e.g., helium, argon, nitrous oxide and mixtures at a flow rate of more than 55 sccm (standard cubic centimeter per minute), establishing a pressure of 1.5 to 9.5 Torr in the PECVD processing temperature, establishing a plasma in the processing temperature, establishing a low pressure in the processing chamber and establishing a plasma in the low pressure chamber.

US 5,043,299 discloses a process for the selective deposition of tungsten on a masked semiconductor, cleaning the surface of the wafer in an air-tight cleaning chamber and then, transferred to a clean vacuum deposition chamber for selective deposition. In the selective tungsten CVD process, the wafer, and base or susceptor is maintained at a temperature from 350 to 500°C when using H₂ as the reducing gas and from 200 to 400°C when using SiH₄ as the reducing gas. Halogen containing gases, e.g., BCl₃ are used for cleaning aluminum oxide surfaces on the wafer and NF₃ or SF₆ are used for cleaning silicon oxides. Also disclosed is a process for cleaning the CVD chamber to remove tungsten residue from previous deposition processes using NF₃ plasma followed by H₂ plasma.

GB 2,183,204 A discloses the use of NF₃ for the *in situ* cleaning of CVD deposition hardware, boats, tubes, and quartz ware as well as semiconductor wafers. NF₃ is introduced to a heated reactor in excess of 350°C for a time sufficient to remove silicon nitride, polycrystalline silicon, titanium silicide, tungsten silicide, refractory metals and silicides.

### BRIEF SUMMARY OF THE INVENTION

This invention relates to an improvement in the cleaning of contaminated tool parts having a coating of unwanted residue formed thereon during deposition in a semiconductor deposition process. In this process, the contaminated tool parts to be cleaned are removed from the semiconductor deposition chamber and placed in an off-line gas reaction chamber which is separate from the semiconductor deposition chamber. The coating of residue on the contaminated parts is removed from the tool parts by contacting the tool parts coated with an unwanted residue with a reactive gas under conditions for forming a volatile species through a reaction with a gas-phase chemical agent while in said off-line gas reaction chamber and then removing the volatile species from said off-line gas reaction chamber.

Significant advantages can be achieved by the process and some of these include:
an ability to dry clean parts, which provides higher throughput, less labor, higher selectivity, and decreased environmental impact;
an ability to clean parts from different reaction chambers which chambers may have employed a different deposition or etching step, or a different treatment time in the same reactor chamber;
an ability to optimize cleaning parameters for tool parts having an undesired amount of residue (thick layer), such as shower heads, shields and the like which parameters are different than the cleaning parameters for fixed location, *in-situ,* deposition chamber cleaning;
an ability to maintain reaction deposition chamber operation by removal and immediate replacement of specific tool parts, thereby contributing to increased production. For example, in *in-situ* reaction chamber cleaning, even if only one fixture needs to be cleaned, the entire chamber has to be taken off-line and treated. With tool parts cleaning off-line by the improved process, the contaminated parts to be cleaned can be removed from the reaction deposition reactor and clean parts immediately replaced in the reaction deposition reactor and the reaction deposition reactor permitted to operate;
an ability to employ a varying gas activation means to increase cleaning efficiency than afforded in an *in situ* cleaning; and,
an ability to achieve chamber cleaning flexibility by off-line reactive gas parts cleaning allowing for a more effective clean, an increase in throughput due to a decrease in downtime for cleaning, and a cost-savings.

### DETAILED DESCRIPTION OF THE INVENTION

This invention is directed to an improvement in a method for cleaning tool parts contaminated with unwanted deposition residue formed thereon during deposition in a semiconductor deposition chamber. During some semiconductor manufacturing processes, such as PVD (physical vapor deposition), sputter deposition, MOCVD (metal organic chemical vapor deposition), ALD (atomic vapor deposition), CVD (chemical vapor deposition), or PECVD (plasma-enhanced chemical vapor deposition), the internal chamber and tool parts become coated with process residue. Tool parts such as showerheads and shields, etc., can also be coated with unwanted material in reactors for flat panel displays and in applications in the coatings industry. The improvement in the tool parts cleaning process resides in removing the contaminated parts from the semiconductor deposition chamber and placing the contaminated parts in an off-line gas reaction chamber. The residue is cleaned from the contaminated tool parts by contacting the tool parts with a reactive gas under conditions for forming a volatile species through reactions with a gas-phase chemical agent and then removing the volatile species from the off-line gas reaction chamber. One of the essential requirements for reactive gas cleaning then is to convert the solid, non-volatile unwanted residue on the contaminated tool parts into a volatile species that can be removed by a vacuum system.

The reactive gases suited for parts cleaning generally are halogen containing gases such as Cl-containing or F-containing compounds. Exemplary compounds are Cl₂, HCl, BCl₃, CF₄, SF₆, CHF₃, and NF₃. A chemically active fluorine species, such as ions and radicals, can be generated by the combination of a plasma and the halogen-containing compounds and the ions and radicals react with the film on the chamber walls and other equipment. The gaseous residue then is swept from the CVD reactor.

The reactive gas as described should have a high selectivity for the deposited residue contained on the contaminated tool parts relative to the base metal of the tool parts. This base metal could be aluminum, titanium, stainless steel, or any other metal from which chamber parts could be made. The high selectivity provides complete cleaning of the parts without any damage to the underlying metal substrate.

The external energy source for effective cleaning in the off-line gas reaction chamber can be provided from thermal heating, remote plasma activation, or *in-situ* plasma activation, or by a combination of thermal heat and a plasma. Higher temperatures can accelerate chemical reactions and make reaction byproducts more volatile. However, there may be practical limitations on the use of temperature alone as the energy source in many semiconductor production deposition chambers. Remote plasma can generate reactive species to facilitate reactions without damage to the substrates caused by ion bombardment.

To illustrate a route to the cleaning of tool parts in an off-line gas reaction chamber, the following is provided. After deposition of unwanted residue has built up to an unacceptable level on tool parts inside a semiconductor deposition chamber, the tool parts to be cleaned are removed from the semiconductor deposition chamber and loaded into an off-line gas reaction chamber. It is necessary that the off-line gas reaction chamber is separate from the semiconductor deposition chamber.

After loading the tool parts into the off-line gas reaction chamber, the chamber is evacuated, to a pressure, typically of 10⁻⁴ Torr or lower. If thermal heat is to be used, the off-line gas reaction chamber can be provided by a resistive heater.

Reactive gases are delivered to the off-line gas reaction chamber from a variety of sources, such as conventional cylinders, safe delivery systems, vacuum delivery systems, or solid or liquid-based generators. If a plasma is to be used as an external energy source, the power to the off-line gas reaction chamber is turned on, the reactive gas is supplied. The resulting plasma is introduced to the off-line reaction chamber.

The resulting plasma is conveyed to the off-line gas reaction chamber. Contaminated tool parts in the off-line dry gas reaction chamber are treated with the reactive gas and the residue on the tool parts is converted by the reactive gas to a volatile species. After a preset time, the plasma power or the heat is turned off and the reactive gas flow stopped. The off-line gas reaction chamber is evacuated and vented. The parts then can be retrieved from the reaction chamber and reused for the semiconductor deposition chamber.

The following examples are intended to illustrate various embodiments of the invention and are not intended to restrict the scope thereof.

### Example 1

Removal of Ta/TaN Using Remote NF₃ Plasma

### General Procedure

An MKS Astron remote plasma generator is mounted on top of the reactor chamber. The distance between the exit of the Astron generator and the sample coupon is about six inches. The test coupons are placed on the surface of a pedestal heater. The heater is used to obtain different substrate temperatures.

In all of the runs, the remote plasma was turned on using a mixture of 400 sccm NF₃ and 400 sccm Ar as the process gas and keeping chamber pressure at 4 Torr.

Experimental samples employed for cleaning of Ta/TaN deposition residue using reactive gas cleaning were cut as 1.5" X 3" rectangles from a 19" shield from a PVD chamber. In each experimental run, to estimate the selectivity between Ta/TaN and the base material, a control sample with only base material (without the contaminating Ta/TaN coating) is put side by side with another sample with the Ta/TaN coating. The original thickness for the Ta/TaN coating is in the range of a tenth of a millimeter. The etch rate is determined by the sample's weight change before and after the reactive gas treatment.

### Test Run

A tool part sample contaminated with a Ta/TaN coating, Sample #2, was used to obtain the Ta/TaN etch rate and a tool part sample having only the base material (Aluminum), Sample #3, was used to check the selectivity for the removal of the contaminant, Ta/TaN, and the base material. After 13 minutes exposure to the remote plasma, Sample 2 having the Ta/TaN coating had a weight loss of 5.7591 g.
Considering the exposed Ta/TaN coating area, which was about 4.5 in², the Ta/TaN etch rate was about 0.1 g/(min·in²), which was higher than that of Si or SiO₂ under the same experimental condition. The remote NF₃ plasma effectively removed the Ta/TaN deposit from Sample 2.

In contrast to the Ta/TaN coated sample (#2), there was no weight loss for the base aluminum sample (#3). Careful visual examination of the Al sample revealed no surface damage.

In conclusion, this off-line cleaning process using an NF₃ activated plasma provides for the high selectivity removal of Ta/TaN coated aluminum based tool parts. In addition, the activated NF₃ causes no damage to the base material. On the other hand, when a wet cleaning process is employed, e.g., one wherein HCl, a typical cleaning agent for this kind of chemical deposition product, damage to the base metal can result.

### Example 2

### Removal of Ta/TaN Using Remote NF₃ Plasma From Stainless Steel (SS) And The Titanium (Ti) Base Materials

The procedure of Example 1 was followed except the base metals of the tool part were stainless steel (SS) and titanium (Ti) instead of aluminum. Similarly, high selectivity was achieved in that there was effective removal of Ta/TaN contaminant film from the tool parts and no damage was found for the SS and Ti materials.

Table 1 sets forth results a summary for the removal of Ta/TaN films from tool parts tested in Examples 1 and 2.

**Table 1:**

| Selectivity Of Ta/TaN Removal Over A Variety Of Base Materials Under A NF₃ Remote Plasma (4 Torr, 400 Sccm NF₃, And 400 Sccm Ar) | | | | | |
|---|---|---|---|---|---|
| Sample coupon | Sample size (in²) | Etch time (min) | Weight loss (g) | Etch rate (g/(min.in²) | Selectivity |
| TaN | 4.5 | 13 | 5.7591 | 0.1 | 1 |
| Al | 4.5 | 13 | 0.0009 | 0 | >1000 |
| SS | 9 | 5 | 0 | 0 | >1000 |
| Ti | 5 | 5 | 0 | 0 | > 1000 |

Summarizing, the data show that off-line removal of Ta/TaN residue films from tool parts can be carried out in an off-line gas reactive gas chamber, separate from the semiconductor deposition chamber, which is capable of forming a volatile species and capable of removal by vacuum from the chamber. Plasma enhanced activation can also aid in the removal of the unwanted deposition residue without injury to the base metal, such as Al, SS, and Ti.

This off-line tool parts cleaning process can be advantageous for a PVD process. Any *in-situ* cleaning of the deposition chamber by remote plasma may cause damage to the target. Conventionally, to avoid damage to the target the tool parts from the PVD processes are cleaned off-line by dipping into a strong acid or caustic solution or by mechanical means such as scrubbing or sand blasting. Neither the wet cleaning nor the mechanical means provide the high selectivity for removal of the unwanted residue from the tool parts with respect to the base materials as with the process described here and in Example 1.

### Example 3

### Removal of TiN from the Surface of a Pedestal Heater

In a typical titanium nitride (TiN) low temperature CVD process, the operating temperature is about 150 °C. Conventionally, because of the design of commercial semiconductor deposition chambers (typically such chambers have an upper design operating temperature of about 200 °C) employed in this kind of low temperature deposition, the chamber is cleaned at low temperatures using a very toxic and corrosive process gas such as ClF₃.

In this example, a pedestal heater was taken from a TiN semiconductor deposition chamber; it had a TiN deposit layer of about 20 µm on its surface. The remote plasma cleaning by the procedure of Example 1 in an off-line gas reaction chamber using NF₃ as the reactive gas was followed, except for the following changes: a small part cut from the pedestal heater was used as the sample and the resistive heater inside the cleaning chamber was turned on and the temperature kept at 150 °C. Within 45 minutes, the titanium nitride residue layer was completely removed from the pedestal heater part. No damage was observed on the pedestal heater's surface.

This example illustrates the off-line cleaning of a pedestal tool part, which may be the only item that required cleaning in the semiconductor deposition chamber, in a dedicated tool parts cleaning reactor. Costly, modifications need not be made to the semiconductor deposition chamber to permit high temperature or remote plasma cleaning using an alternative reactant to the toxic CIF₃.

### Example 4

### Removal of HfO₂ Material

An atomic layer deposition (ALD) process is commonly used to produce HfO₂ film, which can be used as a high dielectric material. The operating temperature for such process is normally less than 150 °C and the deposition chambers are designed for low temperature deposition.

HfO₂ is highly chemical resistive, the *in-situ* cleaning of this material in the semiconductor deposition chamber is difficult. To obtain a reasonable removal rate of HfO₂ from the tool part, a temperature of much higher than 150 °C is required. Under thermal conditions, a temperature of at least 500 °C may be required.

In this example, a HfO₂ coated wafer sample was taken from a ALD deposition chamber and etched in an off-line gas reaction chamber using an elevated temperature. The procedure of Example 1 was followed except for the following changes: the sample was an HfO₂ coated wafer; the process gas was BCl₃; the temperature of the off-line gas reaction chamber was kept at 600 °C and the chamber pressure was kept at 100 Torr. The remote plasma generator was turned off. At such an experimental condition, a HfO₂ etch rate of 1.1 nm/min was obtained.

This example shows that the off-line cleaning of difficult to remove residues can be effected where the removal of deposition residues, *in-situ,* within the semiconductor deposition chamber cannot be performed.

## Claims

1. A process for cleaning a tool part contaminated with a deposition residue which was formed on said tool part in a semiconductor deposition chamber, which comprises:
removing said tool part contaminated with the deposition residue from said semiconductor deposition chamber;
introducing said tool part to an off-line gas reaction chamber;
contacting said tool part with a reactive gas under conditions for converting said deposition residue to a volatile species;
removing said volatile species from said off-line gas reaction chamber;
recovering said tool part essentially free of deposition residue from said off-line gas reaction chamber; and then,
employing said tool part in a semiconductor deposition chamber.

2. The process of Claim 1 wherein the tool part is comprised of a base metal selected from the group consisting of aluminum, stainless steel and titanium.

3. The process of Claim 1 wherein the reactive gas is a halogen-containing gas.

4. The process of Claim 3 wherein the halogen-containing gas is selected from the group consisting of Cl₂, HCl, BCl₃, CF₄, SF₆, CHF₃, NF₃, C₂F₆, and C₃F₈.

5. The process of Claim 3 wherein the reactive gas is activated by thermal or plasma.

6. The process of Claim 3 wherein the tool part is contaminated with a TaN, HfO₂ or TiN film.

7. The process of Claim 3 wherein the reactant gas is NF₃.

8. A process for cleaning tool parts contaminated with residue on its surface, said residue resulting from exposure to deposition material being deposited on a substrate in a semiconductor deposition chamber having an upper design operating temperature of about 200 °C, the improvement for selective cleaning of said tool part and producing a clean tool part which comprises:
removing the tool part from the semiconductor deposition chamber;
placing said tool part in an off-line gas reaction chamber which is separate from the deposition reactor;
contacting said tool part with a gas, while in said off-line gas reaction chamber, under conditions which result in a reaction between said gas and said residue on said tool part that converts said residue to a volatile species resulting in a clean tool part;
removing said volatile species by applying a vacuum to said off-line gas reaction chamber; and,
removing said clean tool part from said off-line gas reaction chamber.

9. The process of Claim 8 wherein said deposition reside is removed in said off-line gas reaction chamber using a reactive gas at a temperature of at least 500 °C.

10. The process of Claim 9 wherein the residue on said tool part is HfO₂.

11. The process of Claim 8 wherein a remote plasma is employed to remove the unwanted residue from said tool part.

12. The process of Claim 8 wherein the residue is formed by low temperature chemical vapor deposition.

13. The process of Claim 12 wherein the reactive gas is NF₃.

14. The process of Claim 13 wherein the residue on said tool part is TiN or TaN.

15. The process of Claim 9 wherein the reactive gas is a halogen-containing gas.

16. The process of Claim 15 wherein the halogen-containing gas is selected from the group consisting of Cl₂, HCl, BCl₃, CF₄, SF₆, CHF₃, NF₃, C₂F₆, and C₃F₈.
